(19) Europäisches Patentamt / European Patent Office / Office européen des brevets

(11) **EP 4 471 437 B1**

(12) **EUROPEAN PATENT SPECIFICATION**

(45) Date of publication and mention of the grant of the patent:
**22.04.2026  Bulletin 2026/17**

(21) Application number: 23196150.9

(22) Date of filing: **08.09.2023**

(51) International Patent Classification (IPC):
**G01R 21/08** *(2006.01)*    **G06F 1/3203** *(2019.01)*
**G01R 21/06** *(2006.01)*    **G06F 11/30** *(2006.01)*

(52) Cooperative Patent Classification (CPC):
**G06F 1/3203; G06F 11/3062;** G01R 21/06;
G01R 21/08

(54) **METHOD FOR DETERMINING ENERGY CONSUMPTION, BY A PROGRAMMABLE INTEGRATED DIGITAL CIRCUIT FOR EXECUTION OF INDIVIDUAL MACHINE INSTRUCTIONS**

VERFAHREN ZUR ERMITTLUNG DES ENERGIEVERBRAUCHS EINER PROGRAMMIERBAREN INTEGRIERTEN DIGITALEN SCHALTUNG ZUR AUSFÜHRUNG EINZELNER MASCHINENBEFEHLE

PROCÉDÉ DE DÉTERMINATION DE LA CONSOMMATION D'ÉNERGIE PAR UN CIRCUIT NUMÉRIQUE INTÉGRÉ PROGRAMMABLE POUR L'EXÉCUTION D'INSTRUCTIONS MACHINE INDIVIDUELLES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **31.05.2023  PL 44509223**

(43) Date of publication of application:
**04.12.2024  Bulletin 2024/49**

(73) Proprietor: **Akademia Gorniczo-Hutnicza im. Stanislawa Staszica w Krakowie 30-059 Krakow (PL)**

(72) Inventors:
• **Las, Patryk**
  **43-332 Pisarzowice (PL)**
• **Wisniowski, Piotr**
  **32-089 Beblo (PL)**

(74) Representative: **Wlasienko, Jozef et al Polservice Kancelaria Rzecznikow Patentowych sp. z o.o. Bobrowiecka 8 00-728 Warszawa (PL)**

(56) References cited:
EP-B1- 3 153 869          US-A- 5 941 991
US-A1- 2003 079 150       US-A1- 2015 028 898
US-B2- 8 930 152

## Description

The subject of the invention is a method for determining energy consumption by a programmable integrated digital circuit for execution of individual machine instructions.

The constantly growing number of mobile devices as well as their degree of development and complexity result in an increase in the energy consumption necessary to power them from limited sources, such as batteries or accumulators. Optimization and reduction of energy consumption by mobile devices is an important element affecting the reliability and effectiveness of their operation. Reducing energy consumption involves, among other things, optimizing power consumption by software running in a device, which is carried out based on accurate power consumption models which are characteristic for a programmable IDC (integrated digital circuit) used in the device.

Functions implemented in digital systems are represented by single machine instructions or entire blocks of them, which are executed by IDC. Each instruction is characterized by a variable number and complexity of elementary operations (e.g. bit shifts, reading/writing operands from memory, etc.) and is often an industrial secret of the digital circuit manufacturer. A clear and precise determination of the energy demand of a digital circuit comes down to measuring the current consumed by the integrated digital circuit during the implementation of its functions, which consists of a series of instructions executed one after another. Single instructions draw currents below $10^{-9}$ A and are executed at a clock speed of several GHz. The measurement of such currents and, consequently, power requires a system with high resolution and measurement accuracy, as well as a precise and non-invasive method of determining the time window in which the execution of the measured instruction took place - its start and end time. Knowledge of the energy consumed by the IDC for the implementation of individual machine instructions allows for a more precise estimation of its energy demand already at the stage of designing the functions it implements in the target digital system, and not, as was the case before, by measuring energy consumption only during the operation of the device.

A method for determining the value of energy necessary to implement a single instruction is known, consisting in repeated (up to 1000 times) execution of the instruction being tested and instructions supporting its implementation by measuring current consumption and a supply voltage value in order to calculate and average values of the energy consumed by the instruction being tested.

From the article V. Tiwari et al "Power Analysis of Embedded Software: A First Step Towards Software Power Minimization,"IEEE Transaction on Very Large Scale Integration (VLSI) Systems, Vol.2, No.4, pp. 437-445, 1994, a method for determining the instruction energy consumption by a microprocessor when executing a specific instruction is known. In this method, the energy consumption of instructions was determined by measuring the average current consumed by the microprocessor during repeated execution (in a loop) of the same instruction. The current was measured using an ammeter.

In the publication J. T. Russell et al, "Software power estimation and optimization for high performance, 32-bit embedded processors," Proc. - IEEE Int. Conf. Comput. Des. VLSI Comput. Process., pp. 328-333, 1998, the method presented in the publication mentioned above was used to measure the power consumption of machine instructions, introducing a different method for determining current consumption during repeated execution of instructions. This difference consisted in determining the current from measuring the voltage drop across the measuring resistor measured using an oscilloscope. The use of an oscilloscope allows direct measurement of the time of repeated execution of instructions.

A number of well-known publications discuss methods of measuring and determining the power and energy consumption of instructions, which basically use the method of measuring current during repeated execution of instructions and execution time, introducing modifications involving the use of various methods and tools for measuring current.

In the publication Ch. Guo et al "A Survey of Energy Consumption Measurement in Embedded Systems", IEEE Access, 9, 60516 2021 [6], a review of methods for measuring the energy consumption of embedded systems was presented, in particular known methods of measuring the energy consumption of machine instructions were discussed. These methods use a method that involves measuring the current during repeated execution of instructions and their execution time. The current measurement is performed directly using an ammeter or indirectly as a voltage drop across a reference resistor, which is measured with an oscilloscope or a system consisting of an amplifier, an analog-to-digital converter and a microcontroller.

Methods for determining the energy consumption of machine instructions known from the state of the art are subject to an error in determining the energy of a single machine instruction because they require repeated and long-term averaging of the energy consumed by looped, repeated execution of the measured instruction. This results in averaging also the supporting instructions of the loop or jump in the performed measurement. Due to this, the obtained result is composed of two elements: the average value of measured instruction and supporting instructions. In this approach, additional loop instructions generate additional energy consumption, which cannot be removed from the averaging process, which increases the error in determining the energy of a single instruction.

Document US 5 941 991 A discloses a method for measuring energy consumption by a programmable integrated digital circuit, wherein the integrated digital circuit is placed in a measurement installation, and wherein continuous measurement of instantaneous power consumed, by the integrated digital circuit is performed.

The inventive problem is to provide a method for measuring energy consumption during the execution of a single machine instruction of an integrated digital circuit that is free from errors of averaging additional supporting instructions.

The object of the invention is to eliminate the error in determining the energy needed to execute a single machine instruction, which consists in the inability to exclude the value of energy consumed by supporting instructions from the measurements when determining the energy value of the measured instruction. This object is achieved by using the method according to the invention, which uses additional information gathered during the measurement of magnetic field generated by a programmable integrated digital circuit, performed simultaneously with the execution of the single instruction.

The essence of a method for determining energy consumption by a programmable integrated digital circuit, for execution of a single machine instruction, according to the invention consists in obtaining a characteristic of instantaneous power consumption within a specified operating time of the programmable integrated digital circuit, implementing an iteration of a single instruction being tested, the implementation of which is supervised by a central control unit, and is characterized by placing the programmable integrated digital circuit, IDC, programmed with a test program that implements a loop of the single machine instruction being tested, in a measurement installation consisting of a power supply system, a power measurement system, a magnetic field probe, a field measurement system and a central control and recording unit, and then initiating an iteration process of the machine instruction being tested. During the iteration of the machine instruction being tested, a continuous measurement of the instantaneous power consumed by the IDC with a resolution of not less than 100 pW and a measurement of a magnetic radiation value $E_{IDC}$, generated by the IDC, are performed. Instantaneous values of the power consumed by the IDC and the magnetic field radiation values $E_{IDC}$, generated by the IDC, are simultaneously stored in an operating memory of the central control unit and synchronized in the time domain, during the implementation of the iteration of the machine instruction being tested, with a resolution of not less than 10 × machine cycle duration of the instruction being tested,

After the iteration is completed and power the IDC is turned off, a time domain characteristic of the measured values of the magnetic field $E_{IDC}$ generated by the IDC during the implementation of the iteration of the machine instruction being tested is analyzed and a repeating pattern of field changes is marked, with a matching coefficient of not less than 90%, and with a duration equal to the number of cycles per instruction being tested × machine cycle duration of this instruction. From the group of marked patterns one pattern is selected which is directly adjacent to the marked identical patterns on both sides. A time interval $T_i$ is determined for the selected pattern by determining its start $t_0$ and its end $t_1$.

Next, samples recorded during the time interval $t_0$ - $t_1$ are extracted from the instantaneous power measurements, and an average value of energy consumed during the implementation of the instruction being tested is determined by summing the extracted instantaneous power measurements over the time interval $t_0$-$t_1$.

The measurements of the values of the magnetic field $E_{IDC}$ in the method implementation are performed while ensuring the conditions for their correct realization, by placing the magnetic field probe with detection efficiency of not less than 1nT in the immediate vicinity of the tested integrated circuit IDC, and both elements of the measurement system are arranged in the space covered by a Faraday cage.

The measurements in the method implementation are performed while ensuring the conditions for their correct realization, by implementing all the connections of the measurement system with shielded cables.

The advantage of the method according to the invention is the development of a method for determining a time window based on the magnetic field analysis in order to determine the power time course, which allows to effectively and efficiently determine the energy consumed by the IDC for the implementation of individual machine instructions of each type, regardless of their complexity (required number of changes in the logical states of the system).

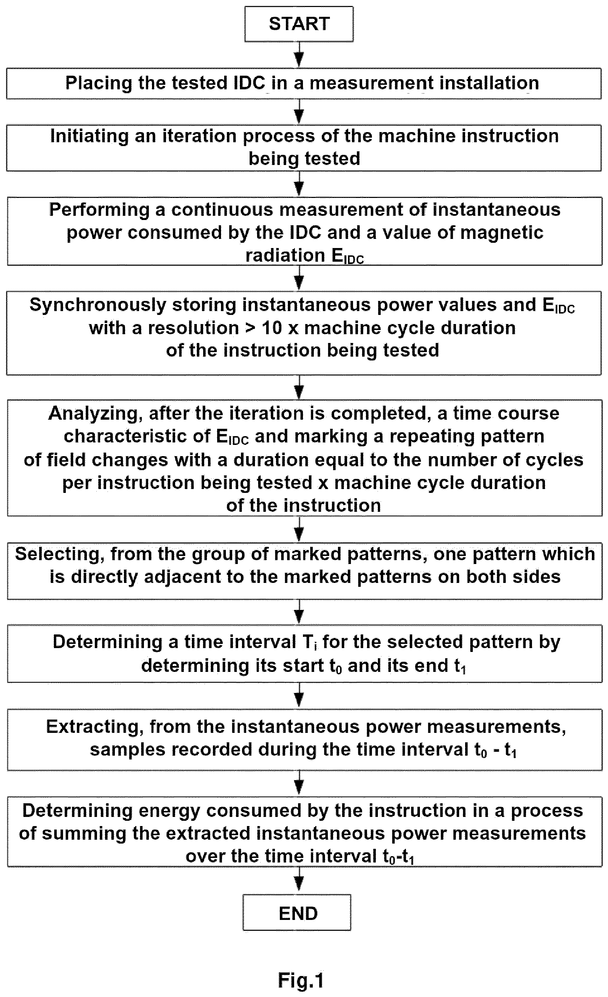

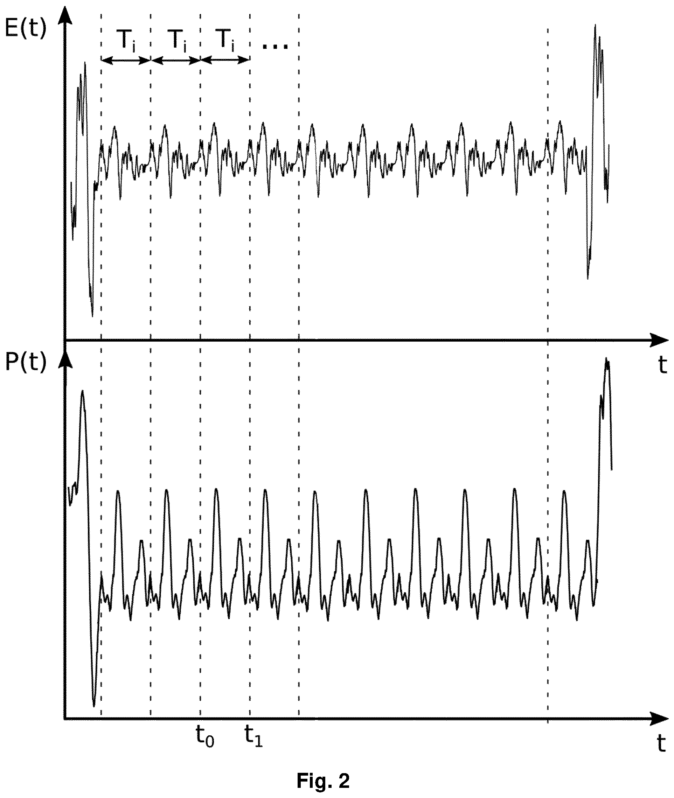

The method according to the invention is explained in an exemplary embodiment shown in the drawing in which Fig. 1 shows a block diagram of an algorithm of the method, Fig. 2 shows a graph of power absorbed by the IDC and magnetic field, and Fig. 3 shows a block diagram of a measurement installation.

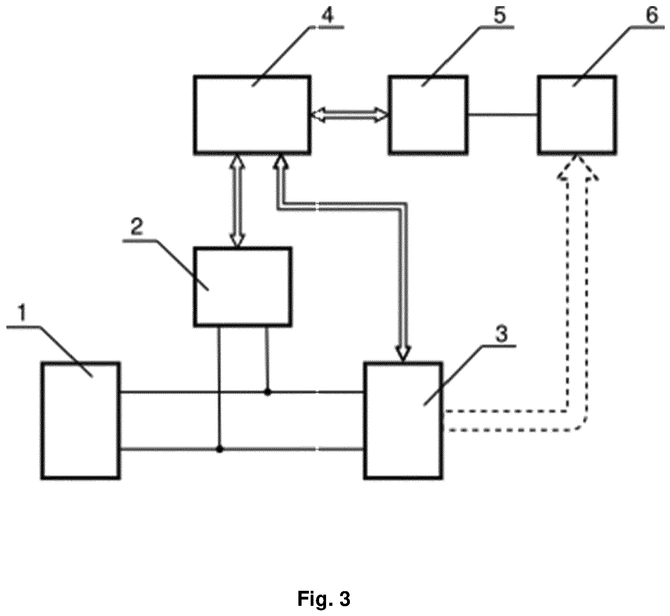

For the implementation of an example of the invention relating to the method for determining energy consumption by a programmable integrated digital circuit (IDC), during execution of individual machine instructions a measurement installation is used, the block diagram of which is presented in fig. 3.

The measurement installation intended for implementing the method according to the invention consists of: a power supply system 1, a power measurement system 2, a development system for the IDC 3, a central control and recording unit 4, a field measurement system 5, and a magnetic field probe 6.

As the power measurement system 1 in the implementation of the invention example a laboratory power supply: Keysight E36311A was used. The power measurement system 2 included a current-voltage converter (transimpedance amplifier DHPCA-100). As the development system for the IDC 3 a development module STMicroelectronics NUCLEO-F334R8 was used. As the central control and recording unit 4 a PC-class computer comprising a PCIe Gen 3 slot (8 lane) equipped with a measuring card - AlazarTech ATS9373 was used. As the field measurement system 5 an amplifier of the field probe with a power supply: EMI-NF-AMP was used. Whereas as the magnetic field probe 6 a field probe: Tektronix EMI-NF-PROBE H20 was used.

The measurement installation was used for testing the IDC in the form of a STM32F334R8 type microcontroller.

The measurement installation was arranged in such a way that to power supply terminals of the development system for the IDC 3 the power supply system 1 was connected, whose current efficiency and output voltage were consistent with the levels specified by the IDC manufacturer. In the power supply path of the development system for the IDC 3 the power measurement system 2 was placed, the measurement resolution of which enables measurement of the power consumed by the IDC with a resolution of not less than 100 pW at a sampling frequency of not less than **30x** the frequency of one clock cycle of a measured instruction.

The field probe 6 was placed in an orientation allowing for the correct measurement of the magnetic radiation emitted by the IDC and at a distance ensuring maximum dynamics of the performed measurements.

The field probe 6 was connected to the field measurement system 5. The field measurement system 5 together with the provided field probe 6 enables measurement of magnetic radiation with a frequency not less than 30x the frequency of one cycle clock of a measured instruction and with magnetic field detection efficiency of not less than 1nT.

The central control and recording unit 4 was connected to the field measurement system 5, the power measurement system 2 and the development system for the IDC 3.

The power supply system was implemented using the laboratory power supply 1 and was connected to the development module for the tested IDC 3 in such a way that the output terminal of the positive pole of the power supply 1 was connected to the JP6 connector of the development module 3 and the output terminal of the negative pole of the power supply (ground in asymmetric mode) was connected to the GND connector of the development module 3. The power measurement system 2 was implemented using channel A of the measuring card included in the central control and recording unit 4 and the current-voltage converter connected in such a way that the current input of the converter was connected to the positive pole of the power supply of the power supply system 1 and the current output of the converter to the JP3 connector of the development module 3 (in a manner consistent with the converter manufacturer's guidelines), while the voltage output of the converter was connected to channel A of the measuring card (power measurement was carried out indirectly, as the quotient of the supply voltage value from the power supply system 1 and the current measured on channel A of the measuring card). The field measurement system 5, implemented using the field probe 6, the amplifier and channel B of the measuring card, which is part of the central control and recording unit 4, was connected in such way that the amplifier output was connected to channel B of the measuring card included in the central control and recording unit 4, and the amplifier input to the field probe 6.

The field probe 6 is placed in contact with the tested IDC installed on the development module 3 in such a way that magnetic field generated by the integrated digital circuit passes through the measurement plane of the field probe 6 - field measurement is to be consistent with the art of field measurement.

The amplifier of the field measurement system 5 is powered by a dedicated power supply.

The Auxiliary I/O control signal of the measuring card, which is part of the central control and recording unit 4, was connected to the CN3 connector slot of the development module 3, and the signal ground of the Auxiliary I/O connector to the GND connector of the development module 3. The measuring card, which is part of the central control and recording unit 4, was installed in the PC-class computer having a compatible communication bus, thus implementing the central control unit of the measurement installation.

The batch program for the IDC was prepared in such a way that the microprocessor (STM32F334R8) was clocked at 20 MHz (configuration of the external 8MHz oscillator fed to the internal PLL loop) and the main program after detecting a rising edge on the input port of the digital integrated circuit connected to the central control and recording unit 4 began executing an infinite program loop in which the measured instruction was called 10 times (not less than 3 times according to the method of the invention) - for example, the logical "AND" instruction was used.

After uploading the software to the IDC and completing the installation, the power supply system 1 was started to supply the development module with voltage of 2V. Then, at the software level of PC, the measuring card, which is part of the central control and recording unit 4, was configured to ensure the maximum frequency and measurement resolution (2GS/s for 12bit) while simultaneously recording measurements on both measurement channels (A and B) and so that the measurement and recording cycle begins when the high state is activated (change from 0V to 2V) at the Auxiliary I/O output and that this beginning lasts for at least the duration of 10 instruction calls - for the exemplary AND instruction, the duration of one call is 1 clock cycle = 50ns .

From the level of the control application of the measuring card, which is part of the central control and recording unit 4, the high state at the Auxiliary I/O output was activated, thus activating an infinite loop of execution of the set of instructions on the integrated digital circuit and starting the measurement and recording process of the card.

The collected measurement data (for field and current), synchronized in time by the measurement card, were analyzed using external software.

In the field measurements, a repeating pattern was searched for with a length equal to the duration of a single call of the instruction being tested (50ns in the example), so that the repeating pattern occurred no less than 3 times in succession. A correlation method with a matching coefficient of not less than 95% was used in the example. As the searched pattern a section of the recorded signal equal to the duration of the measured instruction was used (50ns in the example, which corresponds to a block size of 2GS/s * 50ns = 100 samples). In subsequent iterations of running the correlation algorithm, this section was selected such that the first sample of the block has the number N, where N={1,...,$N_{MAX}$}, $N_{MAX}$=7*2GS/s*50ns = 700. Subsequent iterations were performed until groups of at least 3 directly repeating patterns in the recorded field signal were detected or until $N_{MAX}$ iteration was reached. From the group of repeating patterns, one was selected which was directly adjacent to the other detected patterns on both its left and right sides (at least one on each side). For the selected pattern, the number of its first sample (S0) was read and the number of the last one (S1) was determined by adding the block size to the first sample (S1 = S0 +100). Sample numbers S0 and S1 represent the discrete start and end times of the selected pattern.

As channels A and B of the measuring card were synchronized in the time domain, the sample numbers of both channels of the measuring card, which is part of the central control and recording unit 4, corresponded to the same moments of time both for the measurement of the instantaneous value of the field and the instantaneous value of the current consumed by the integrated digital circuit. Using this property, the instantaneous value of the power consumed by the measured instruction for individual current measurement samples was determined as the product of the instantaneous value of the current and the supply voltage:

$$P(n) = I(n) \cdot U \ ,$$

where

> $n$ is a measurement sample index (from the range S0 - S1),
> $I(n)$ is a value of the measured current for sample n,
> $P(n)$ is a determined instantaneous value of power for sample n
> and this, in turn, allowed to calculate the energy consumed by the programmable integrated digital circuit during the execution of the measured instruction according to the formula: $W = \sum_{n=S0}^{S1} P(n)$ ,
> where W is the energy consumed by IDC during execution of the instruction being tested.

The determined value of energy consumed by the programmable IDC during the execution of the AND instruction being tested in the exemplary implementation of the invention was W ~ = 823.01 [nJ].

The invention will find application in the design of electronic systems, e.g. battery-powered sensors, used in hard-to-reach places, installed in an inaccessible way, which excludes or significantly complicates battery replacement and wired data transmission. Maximum reduction of energy consumption of designed electronic systems is one of the factors increasing the operating time of such systems and ensuring longer failure-free operation, which affects the operating costs, especially when a large number of devices of this type are used.

## Claims

1. A method for determining energy consumption by a programmable integrated digital circuit, for execution of individual machine instructions, consisting in obtaining a characteristic of instantaneous power consumption within a specified operating time, of the programmable integrated digital circuit implementing an iteration of a single instruction being tested, the implementation of which is supervised by a central control unit, **characterized by**

> - placing the programmable integrated digital circuit, IDC (3), programmed with a test program that implements a loop of the single machine instruction being tested, in a measurement installation consisting of a power supply system (1), a power measurement system (2), a field probe (6), a field measurement system (5), and a central control and recording unit (4)
> - initiating an iteration process of the machine instruction being tested,
> - performing a continuous measurement of the instantaneous power consumed by the IDC with a resolution of not less than 100 pW using the power measurement system (2) and a measurement of a radiation value of magnetic field $E_{IDC}$, generated by the IDC, using the field probe (6) and the field measurement system (5), during the implementation of the iteration of the machine instruction being tested,
> - simultaneously storing, in an operating memory of the central control unit (4), and synchronizing in the time domain, instantaneous values of the power consumed by the IDC and measured values of the magnetic field $E_{IDC}$, with a resolution of not less than $10 \times$ machine cycle duration of the instruction being tested,
> - analyzing, after the iteration is completed and power of the IDC is turned off, a time course characteristic of the measured values of the magnetic field $E_{IDC}$ generated by the IDC during the implementation of the iteration of the machine instruction being tested and marking a repeating pattern of magnetic field changes, with a matching coefficient of not less than 90%, with a duration equal to the number of cycles per instruction being tested $\times$ machine cycle duration of this instruction,

- selecting, from the group of marked patterns of the magnetic field time course, one pattern which is directly adjacent to the marked patterns on both sides,

- determining a time interval $T_i$ for the selected pattern by determining its start $t_0$ and its end $t_1$,

- extracting, from the instantaneous power measurements, samples recorded during the time interval $t_0 - t_1$ determined from the synchronized magnetic field measurements,

- determining energy consumed in the implementation process of the single instruction being tested by summing the extracted instantaneous power measurements over the time interval $t_0 - t_1$.

2. The method for determining energy consumption according to claim 1 **characterized in that** the magnetic field probe is situated in the immediate vicinity of the tested IDC and both elements of the measurement system are preferably arranged in the space covered by a Faraday cage.

3. The method for determining energy consumption according to claim 1 **characterized in that** all the connections of the measurement system are made of shielded cables.

4. The method for determining energy consumption according to claim 1 **characterized in that** the field probe is a magnetic field probe with detection efficiency of not less than 1nT.


**Patentansprüche**

1. Verfahren zur Bestimmung des Energieverbrauchs einer programmierbaren integrierten digitalen Schaltung zur Ausführung einzelner Maschinenbefehle, bestehend in der Ermittlung einer Kennlinie der momentanen Leistungsaufnahme innerhalb einer bestimmten Betriebszeit der programmierbaren integrierten digitalen Schaltung, die eine Iteration eines einzelnen zu testenden Befehls ausführt, dessen Ausführung von einer zentralen Steuereinheit überwacht wird, **dadurch gekennzeichnet, dass**:

   - die programmierbare integrierte digitale Schaltung IDC (3), die mit einem Testprogramm programmiert ist, das eine Schleife eines einzelnen zu testenden Maschinenbefehls ausführt, in einer Messanlage angeordnet ist, die aus einem Stromversorgungssystem (1), einem Leistungsmesssystem (2), einer Feldsonde (6), einem Feldmesssystems (5) und einer zentralen Steuer- und Aufzeichnungseinheit (4) besteht,

- ein Iterationsprozess des zu testenden Maschinenbefehls eingeleitet wird,

- eine kontinuierliche Messung der von der IDC-Schaltung aufgenommenen Momentanleistung mit einer Auflösung von mindestens 100 pW unter Verwendung eines Leistungsmesssystems (2) und eine Messung eines Wertes des von der IDC-Schaltung erzeugten Magnetfeldes $E_{IDC}$ unter Verwendung einer Feldsonde (6) und eines Feldmesssystems (5) während der Ausführung der Iteration des zu testenden Maschinenbefehls durchgeführt werden,

- in einem Arbeitsspeicher der zentralen Steuereinheit (4) gleichzeitig und synchronisiert im Zeitbereich die Momentanwerte der von der IDC-Schaltung aufgenommenen Leistung und die gemessenen Werte des Magnetfelds $E_{IDC}$ mit einer zeitlichen Auflösung von mindestens dem Zehnfachen der Dauer des Maschinenzyklus des zu testenden Befehls gespeichert werden,

- nach Beendigung der Iteration und Abschalten der IDC-Stromversorgung eine Analyse des zeitlichen Verlaufs der gemessenen Werte des von der IDC-Schaltung während der Ausführung des zu testenden Maschinenbefehls erzeugten Magnetfelds $E_{IDC}$ durchgeführt wird und ein sich wiederholendes Muster von Magnetfeldänderungen mit einem Übereinstimmungskoeffizienten von mindestens 90 % und einer Dauer, die der Anzahl der Zyklen pro zu testendem Befehl $\times$ der Dauer des Maschinenzyklus dieses Befehls entspricht, markiert wird,

- aus der Gruppe der markierten Muster des zeitlichen Verlaufs des Magnetfelds ein Muster ausgewählt wird, das unmittelbar an die markierten Muster auf beiden Seiten angrenzt,

- für das ausgewählte Muster ein Zeitintervall $T_i$ durch Festlegung seines Startzeitpunkts $t_0$ und Endzeitpunkts $t_1$ bestimmt wird,

- aus den Momentanleistungsmessungen Proben extrahiert werden, die im Zeitintervall $t_0 - t_1$ aufgezeichnet wurden, das auf der Grundlage synchronisierter Magnetfeldmessungen bestimmt wurde,

- die im Verlauf der Ausführung eines einzelnen zu testenden Befehls aufgenommene Energie durch Summierung der extrahierten Momentanleistungsmessungen im Zeitintervall $t_0 - t_1$ bestimmt wird.

**2.** Verfahren zur Bestimmung des Energieverbrauchs nach Anspruch 1, **dadurch gekennzeichnet, dass** die Magnetfeldsonde in unmittelbarer Nähe der zu testenden IDC-Schaltung angeordnet ist und beide Elemente des Messsystems vorzugsweise in einem von einem Faraday-Käfig abgedeckten Raum positioniert sind.

**3.** Verfahren zur Bestimmung des Energieverbrauchs nach Anspruch 1, **dadurch gekennzeichnet, dass** alle Verbindungen des Messsystems mit abgeschirmten Kabeln hergestellt werden.

**4.** Verfahren zur Bestimmung des Energieverbrauchs nach Anspruch 1, **dadurch gekennzeichnet, dass** die Feldsonde eine Magnetfeldsonde mit einer Detektionsfähigkeit von mindestens 1 nT ist.

**Revendications**

**1.** Méthode de détermination de la consommation d'énergie par un circuit intégré numérique programmable destiné à exécuter des instructions-machine individuelles, consistant à obtenir la caractéristique de la consommation instantanée d'énergie pendant un temps de fonctionnement donné du circuit intégré numérique programmable exécutant l'itération d'une seule instruction testée, dont l'exécution est supervisée par une unité centrale de commande, **caractérisée en ce que** :

- le circuit intégré numérique programmable, IDC (3), programmé avec un programme de test exécutant la boucle d'une seule instruction-machine testée, est placé dans une installation de mesure composée d'un circuit d'alimentation (1), d'un circuit de mesure de puissance (2), d'une sonde de champ (6), d'un système de mesure de champ (5) et d'une unité centrale de commande et d'enregistrement (4) ;
- le processus d'itération de l'instruction-machine testée est lancé ;
- une mesure continue de la puissance instantanée consommée par l'IDC est effectuée, avec une résolution d'au moins 100 pW, à l'aide du système de mesure de puissance (2), ainsi que la mesure de la valeur du champ magnétique $E_{IDC}$ généré par l'IDC, à l'aide d'une sonde de champ (6) et du système de mesure de champ (5) pendant l'exécution de l'itération de l'instruction-machine testée ;
- les valeurs instantanées de la puissance consommée par l'IDC et les valeurs mesurées du champ magnétique $E_{IDC}$ sont enregistrées simultanément dans la mémoire opérationnelle de l'unité centrale de commande (4), avec la synchronisation temporelle et une résolution d'au moins dix fois la durée du cycle machine de l'instruction testée,
- à la fin de l'itération, et après la mise hors tension de l'IDC, est effectuée une analyse de la courbe temporelle caractéristique des valeurs mesurées du champ magnétique $E_{IDC}$ généré par l'IDC pendant l'exécution de l'itération de l'instruction-machine testée, et un motif répétitif de variations du champ magnétique est marqué, avec un coefficient d'ajustement d'au moins 90 % et une durée égale au nombre de cycles par instruction testée $\times$ la durée du cycle machine de cette instruction,
- parmi le groupe des motifs marqués de courbe temporelle du champ magnétique, est choisi un motif directement adjacent aux motifs marqués, des deux côtés,
- pour le motifs choisi, l'intervalle de temps $T_i$ est déterminé en définissant son temps initial $t_0$ et final $t_1$,
- parmi les mesures de puissance instantanée, des échantillons sont extraits, enregistrés dans l'intervalle de temps $t_0$ - $t_1$ déterminé sur la base des mesures synchronisées du champ magnétique,
- l'énergie consommée dans le processus d'exécution d'une seule instruction testée est déterminée en additionnant les mesures de puissance instantanée extraites dans l'intervalle de temps $t_0$-$t_1$.

**2.** Méthode de détermination de la consommation d'énergie selon la revendication 1, **caractérisée en ce que** la sonde de champ magnétique est placée à proximité immédiate de l'IDC testé et que les deux éléments du système de mesure sont de préférence disposés dans un espace couvert par une cage de Faraday.

**3.** Méthode de détermination de la consommation d'énergie selon la revendication 1, **caractérisée en ce que** toutes les connexions du système de mesure sont réalisées au moyen de câbles blindés.

**4.** Méthode de détermination de la consommation d'énergie selon la revendication 1, **caractérisée en ce que** la sonde de champ est une sonde de champ magnétique ayant une sensibilité de détection d'au moins 1 nT.

```
┌─────────────┐
│    START    │
└─────────────┘
       │
       ▼
┌──────────────────────────────────────────────────────────┐
│    Placing the tested IDC in a measurement installation   │
└──────────────────────────────────────────────────────────┘
       │
       ▼
┌──────────────────────────────────────────────────────────┐
│   Initiating an iteration process of the machine instruction │
│                      being tested                         │
└──────────────────────────────────────────────────────────┘
       │
       ▼
┌──────────────────────────────────────────────────────────┐
│   Performing a continuous measurement of instantaneous    │
│      power consumed by the IDC and a value of magnetic    │
│                    radiation $E_{IDC}$                    │
└──────────────────────────────────────────────────────────┘
       │
       ▼
┌──────────────────────────────────────────────────────────┐
│  Synchronously storing instantaneous power values and $E_{IDC}$ │
│    with a resolution > 10 x machine cycle duration        │
│            of the instruction being tested                │
└──────────────────────────────────────────────────────────┘
       │
       ▼
┌──────────────────────────────────────────────────────────┐
│    Analyzing, after the iteration is completed, a time course │
│     characteristic of $E_{IDC}$ and marking a repeating pattern │
│  of field changes with a duration equal to the number of cycles │
│    per instruction being tested x machine cycle duration  │
│                   of the instruction                      │
└──────────────────────────────────────────────────────────┘
       │
       ▼
┌──────────────────────────────────────────────────────────┐
│  Selecting, from the group of marked patterns, one pattern which │
│    is directly adjacent to the marked patterns on both sides │
└──────────────────────────────────────────────────────────┘
       │
       ▼
┌──────────────────────────────────────────────────────────┐
│    Determining a time interval $T_i$ for the selected pattern by │
│         determining its start $t_0$ and its end $t_1$     │
└──────────────────────────────────────────────────────────┘
       │
       ▼
┌──────────────────────────────────────────────────────────┐
│   Extracting, from the instantaneous power measurements,  │
│       samples recorded during the time interval $t_0$ - $t_1$ │
└──────────────────────────────────────────────────────────┘
       │
       ▼
┌──────────────────────────────────────────────────────────┐
│  Determining energy consumed by the instruction in a process │
│   of summing the extracted instantaneous power measurements │
│              over the time interval $t_0$-$t_1$           │
└──────────────────────────────────────────────────────────┘
       │
       ▼
┌─────────────┐
│     END     │
└─────────────┘
```

Fig.1

Fig. 2

**Fig. 3**

REFERENCES CITED IN THE DESCRIPTION

**Patent documents cited in the description**

- US 5941991 A

**Non-patent literature cited in the description**

- **V. TIWARI et al.** Power Analysis of Embedded Software: A First Step Towards Software Power Minimization. *IEEE Transaction on Very Large Scale Integration (VLSI) Systems*, 1994, vol. 2 (4), 437-445
- **J. T. RUSSELL et al.** Software power estimation and optimization for high performance, 32-bit embedded processors. *Proc. - IEEE Int. Conf. Comput. Des. VLSI Comput. Process.*, 1998, 328-333
- **CH. GUO et al.** A Survey of Energy Consumption Measurement in Embedded Systems. *IEEE Access*, 2021, vol. 9, 60516